(19) Europäisches Patentamt / European Patent Office / Office européen des brevets

(11) **EP 4 140 859 B1**

(12) **EUROPEAN PATENT SPECIFICATION**

(45) Date of publication and mention
of the grant of the patent:
**31.07.2024  Bulletin 2024/31**

(21) Application number: **21813301.5**

(22) Date of filing: **19.03.2021**

(51) International Patent Classification (IPC):
**B62D 25/00** (2006.01)  **G06F 30/15** (2020.01)
**G06F 30/20** (2020.01)  **B62D 27/02** (2006.01)
**G06F 30/23** (2020.01)

(52) Cooperative Patent Classification (CPC):
**G06F 30/15; G06F 30/20; G06F 30/23;** Y02T 10/40

(86) International application number:
**PCT/JP2021/011350**

(87) International publication number:
**WO 2021/240964 (02.12.2021 Gazette 2021/48)**

(54) **METHOD AND DEVICE FOR OPTIMIZATION ANALYSIS OF JOINING POSITION IN AUTOMOTIVE BODY**

VERFAHREN UND VORRICHTUNG ZUR OPTIMIERUNG DER ANALYSE DER VERBINDUNGSPOSITION IN EINER KRAFTFAHRZEUGKAROSSERIE

PROCÉDÉ ET DISPOSITIF D'ANALYSE D'OPTIMISATION DE POSITION D'ASSEMBLAGE DANS UNE CARROSSERIE DE VÉHICULE AUTOMOBILE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **23.05.2020   JP 2020090146**

(43) Date of publication of application:
**01.03.2023   Bulletin 2023/09**

(73) Proprietor: **JFE Steel Corporation
Tokyo 100-0011 (JP)**

(72) Inventor: **SAITO, Takanobu
Tokyo 100-0011 (JP)**

(74) Representative: **Grünecker Patent- und Rechtsanwälte
PartG mbB
Leopoldstraße 4
80802 München (DE)**

(56) References cited:
**EP-A1- 3 525 115      WO-A1-2014/073018
JP-A- 2012 133 672    JP-A- 2013 025 593**

## Description

Field

The present invention relates to an optimization analysis method and device of a joining position of an automotive body, and more particularly to an optimization analysis method and device for optimizing a joining position of an automotive body for improving dynamic stiffness related to vibration characteristics of an automotive body of an automobile.

Background

Indices of stiffness of a structural body include static stiffness and dynamic stiffness. The static stiffness is improved when the spring constant is increased independently of the mass of the structural body according to Hooke's law. On the other hand, in the dynamic stiffness, the shape of the structural body is periodically changed by the input of the periodic load from the vibration point, and the vibration characteristics are related. For example, the dynamic stiffness in vibration of a single-degree of freedom system is evaluated by a frequency $\omega$ expressed by $\omega = (K/M)^{0.5}$ using a stiffness K (corresponding to stiffness matrix in case of vibration of multi-degree of freedom system) of the structural body and a mass M of the structural body, and the dynamic stiffness is improved as the frequency $\omega$ increases by increasing the stiffness K.

However, even if the stiffness K of the structural body increases, the frequency $\omega$ may not increase if the mass M increases in many cases, and in such a case, the dynamic stiffness is not improved. Therefore, in order to improve the dynamic stiffness, it is necessary to improve the stiffness K to promote weight reduction (mass M reduction) of the structural body. However, in general, when the mass M increases, the stiffness K also increases. Therefore, there are many cases where the stiffness K increase and weight reduction contradict each other, and it is very difficult to achieve both simultaneously. Therefore, conventionally, trial and error has been performed to optimize the vibration characteristics of the structural body and improve the dynamic stiffness.

In recent years, weight reduction of automotive bodies due to environmental problems has been promoted particularly in the automotive industry, and analysis by computer aided engineering (hereinafter, the analysis is referred to as "CAE analysis") has become an essential technique for automotive body design. In this CAE analysis, it is known that stiffness improvement and weight reduction of a structural body are achieved by using optimization techniques such as mathematical optimization, sheet thickness optimization, shape optimization, and topology optimization, and for example, the CAE analysis is often used for structural optimization of casting such as an engine block.

Among optimization techniques, topology optimization is attracting attention in particular. The topology optimization is a method in which a design space having a certain size is provided in a structural body, a three-dimensional element is incorporated in the design space, a given condition is satisfied, and an optimal shape satisfying the condition is obtained by leaving a minimum necessary portion of the three-dimensional element. Therefore, for topology optimization, a method of performing direct constraint on a three-dimensional element forming a design space and directly applying a load is used.

As a technique related to such topology optimization, Patent Literature 1 discloses a topology optimization method of a component of a complex structural body. Furthermore, for the purpose of improving the stiffness of the entire automotive body while reducing the joining amount of a plurality of components in a structural body such as an automotive body by welding or the like as much as possible, Patent Literature 2 discloses a method of obtaining an optimized position of point joining or continuous joining used for joining a plurality of parts constituting the automotive body by topology optimization.

Citation List

Patent Literature

    Patent Literature 1: JP 2010-250818 A
    Patent Literature 2: JP 2013-25593 A

Summary

Technical Problem

In the method of Patent Literature 2, optimization analysis is performed in order to improve static stiffness of a vehicle body, and in the optimization analysis, one or more fixed joining points at which a plurality of components in a structural body model of the automotive body is always joined as a parts assembly are set. However, the optimization analysis disclosed in Patent Literature 2 is not intended to improve the dynamic stiffness of the automotive body, and does not directly optimize the joining positions of the automotive body using the vibrating automotive body by inputting a periodic load to the automotive body as a target. In addition, the obtained joining position is effective for static stiffness, but is not necessarily an optimized joining position for improving the dynamic stiffness of the automotive body.

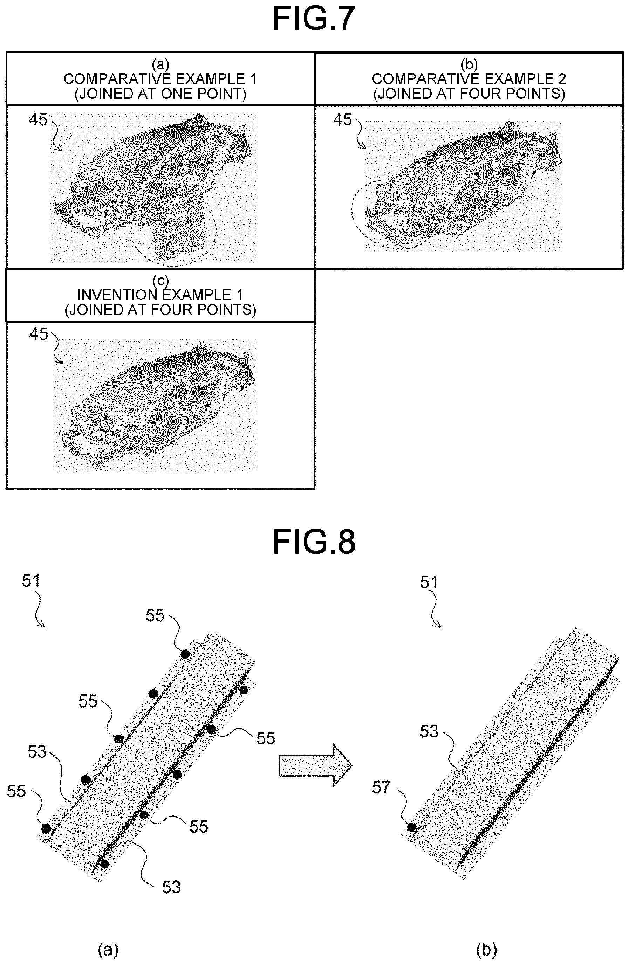

In order to obtain the optimized joining position for improving the dynamic stiffness of the automotive body, it is necessary to perform dynamic analysis that handles the dynamic behavior of the vibrating automotive body. Therefore, similarly to the method of Patent Literature 2, an automotive body model in which a plurality of parts is joined as a parts assembly is used, and first, as illustrated in FIG. 8, one fixed joining point 57 is selected from joining points 55 in a flange portion 53 of a parts assembly 51. Furthermore, one fixed joining point was set for each parts assembly, and dynamic analysis of the automotive body model was performed. However, when the dynamic analysis is performed, flapping occurs in the parts constituting the parts assembly, the vibration is amplified, the parts greatly deviates, or some parts assemblies are separated, and there is a problem that the dynamic analysis cannot be appropriately performed.

As described above, in order to prevent the occurrence of flapping or the like of the parts in the dynamic analysis, it is also conceivable to apply a method of performing dynamic analysis while leaving all the joining points of the parts assembly set in advance in the automotive body model, and obtaining an optimized joining point to be joined in addition to the joining points. However, in the method of obtaining such an additional joining point, the number and positions of joining points or joining areas to be added to be a target of optimization analysis are limited, and there is a problem that it is difficult to achieve both improvement in dynamic stiffness and weight reduction, for example, the joining amount of the entire automotive body cannot be sufficiently reduced as desired.

The present invention has been made in view of the above problems, and an object of the present invention is to provide an optimization analysis method and device of a joining position of an automotive body for obtaining an optimized position of a joining point or a joining area at which a parts assembly of the automotive body is joined while preventing flapping, deviation, and separation of the parts assembly and achieving both dynamic stiffness and weight reduction of the automotive body in dynamic analysis for improving dynamic stiffness related to vibration characteristics of the automotive body.

Solution to Problem

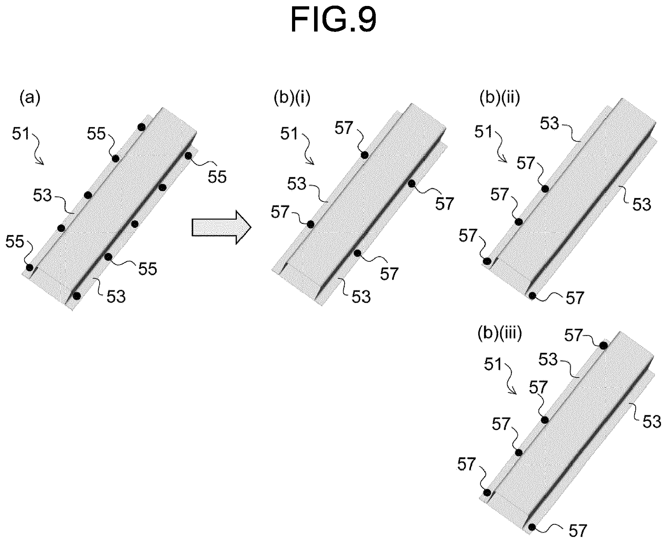

The inventors of the present invention have intensively studied a method for solving the above problems. First, in the method described in Patent Literature 2, since one fixed joining point is selected, flapping occurs in the parts assembly, and the parts assembly deviates or become separated. Therefore, four or more fixed joining points are set by increasing the number of fixed joining points. That is, at the two fixed joining points, a one flange of the parts assembly or one end portion of the part becomes uneven, and the parts assembly is likely to deviate or become separated due to flapping. In addition, even at the three fixed joining points, two fixed joining points are set at one end portion and one fixed joining point is set at the other end portion of the part, and thus, unevenness occurs and flapping of the parts assembly is likely to occur. Therefore, four or more fixed joining points considered to be less uneven are set. In addition, in order to reliably fix the parts to each other, attention is paid to strain energy of the joining point, and as illustrated in FIG. 9 (a), static analysis such as stiffness analysis is performed on an automotive body model in which the joining points 55 is set in advance in the flange portion 53 of the parts assembly 51 to which a plurality of parts is joined, and four or more fixed joining points 57 are selected in descending order of strain energy from the joining points 55 for the parts assembly 51.

However, also in the method of setting four or more fixed joining points in descending order of strain energy, when four fixed joining points are taken as an example, as illustrated in FIG. 9 (b), the four selected fixed joining points 57 are unevenly selected near the center in the longitudinal direction of the flange portion 53 which is a portion to which the parts assembly 51 is joined (FIGS. 9 (b) (i)), or selected unevenly on one flange portion 53 (FIGS. 9 (b) (ii) and 9 (b) (iii)). Then, when the dynamic analysis is performed on the automotive body model in which the fixed joining points 57 is unevenly set in this way, as described above, there are problems that the parts joining the parts assembly flaps and become separated, the parts greatly deviate from the portion joining the parts assembly, and some of the parts assemblies become separated.

Therefore, the inventor of the present invention has intensively studied a method for solving such flapping or the like of the parts in the dynamic analysis. As a result, it has been conceived that four or more fixed joining points are set in each parts assembly, and a distance between each of the four or more fixed joining points is selected as far as possible. Then, the present inventors have obtained a finding that, in the case of the automotive body model in which the distance between each of the four or more fixed joining points is set to be long as described above, dynamic analysis can be performed without deviation of the parts from the portion to be joined in the parts assembly.

The present invention has been made based on such findings, and specifically includes the following configurations.

An optimization analysis method of a joining position of an automotive body according to the present invention performs, by a computer, an optimization analysis of obtaining an optimized position of point joining or continuous joining used for joining of a parts assembly by performing each of following processes on an automotive body model of an automobile including a plurality of parts and joining the plurality of parts as a parts assembly at a joining point or a joining area, and includes: a joining candidate setting process of setting a joining candidate at a position that is a candidate for joining the parts assembly; a fixed joining selection process of selecting four or more fixed joining points or fixed joining areas to be necessarily joined for each parts assembly from among the joining candidates set for each parts assembly; and a joining optimization analysis process of setting, in the automotive body model, the fixed joining point or the fixed joining area selected for each parts assembly without being a target of the optimization analysis and an optimal joining candidate to be a target of the optimization analysis, and performing an optimization analysis of obtaining an optimized joining point or joining area that joins the parts assembly in the automotive body model excluding the fixed joining point or the fixed joining area selected for each parts assembly, wherein he fixed joining selection process includes: a first fixed joining selection step of performing a static analysis or a dynamic analysis on the automotive body model in which the joining candidates are set, and selecting a first fixed joining point or fixed joining area from among the joining candidates for each parts assembly based on a result of the static analysis or the dynamic analysis, a second fixed joining selection step of selecting a joining candidate having a farthest distance from the first fixed joining point or fixed joining area as a second fixed joining point or fixed joining area in the parts assembly, a third fixed joining selection step of selecting a joining candidate having a farthest distance from a midpoint on a straight line connecting the first fixed joining point or fixed joining area and the second fixed joining point or fixed joining area as a third fixed joining point or fixed joining area, and a fourth fixed joining selection step of selecting a joining candidate having a farthest distance from the third fixed joining point or joining area among the joining candidates excluding the first fixed joining point or fixed joining area and the second fixed joining point or fixed joining area as a fourth fixed joining point or fixed joining area.

The first fixed joining selection step of the fixed joining selection process may select a joining candidate having a largest strain energy as the first fixed joining point or fixed joining area.

The first fixed joining selection step of the fixed joining selection process may select a joining candidate having a largest resultant force of a tensile stress and a shear stress as the first fixed joining point or fixed joining area.

The fixed joining selection process may set a center of the joining candidate as a representative point, and calculate the distance in a round-robin manner for the joining candidate in each parts assembly.

An optimization analysis device of a joining position of an automotive body according to the present invention performs an optimization analysis of obtaining an optimized position of point joining or continuous joining used for joining of a parts assembly on an automotive body model of an automobile including a plurality of parts and joining the plurality of parts as a parts assembly at a joining point or a joining area, and includes: a joining candidate setting unit configured to set a joining candidate at a position that is a candidate for joining the parts assembly; a fixed joining selection unit configured to select four or more fixed joining points or fixed joining areas to be necessarily joined for each parts assembly from among the joining candidates set for each parts assembly; and a joining optimization analysis unit configured to set, in the automotive body model, the fixed joining point or the fixed joining area selected for each parts assembly without being a target of the optimization analysis and an optimal joining candidate to be a target of the optimization analysis, and perform an optimization analysis of obtaining an optimized joining point or joining area that joins the parts assembly in the automotive body model excluding the fixed joining point or the fixed joining area selected for each parts assembly, wherein the fixed joining selection unit includes: a first fixed joining selection unit configured to perform a static analysis or a dynamic analysis on the automotive body model in which the joining candidates are set, and selecting a first fixed joining point or fixed joining area from among the joining candidates for each parts assembly based on a result of the static analysis or the dynamic analysis, a second fixed joining selection unit configured to select a joining candidate having a farthest distance from the first fixed joining point or fixed joining area as a second fixed joining point or fixed joining area in the parts assembly, a third fixed joining selection unit configured to select a joining candidate having a farthest distance from a midpoint on a straight line connecting the first fixed joining point or fixed joining area and the second fixed joining point or fixed joining area as a third fixed joining point or fixed joining area, and a fourth fixed joining selection unit configured to select a joining candidate having a farthest distance from the third fixed joining point or joining area among the joining candidates excluding the first fixed joining point or fixed joining area and the second fixed joining point or fixed joining area as a fourth fixed joining point or fixed joining area.

The first fixed joining selection unit of the fixed joining selection unit may select a joining candidate having a largest strain energy as the first fixed joining point or fixed joining area.

The first fixed joining selection unit of the fixed joining selection unit may select a joining candidate having a largest resultant force of a tensile stress and a shear stress as the first fixed joining point or fixed joining area.

The fixed joining selection unit may set a center of the joining candidate as a representative point, and calculate the distance in a round-robin manner for the joining candidate in each parts assembly.

Advantageous Effects of Invention

According to the present invention, it is possible to suppress flapping between parts and deviation or separation of parts in dynamic analysis for optimization analysis of a joining position, and it is possible to obtain an optimized joining position for improvement of dynamic stiffness of an automotive body or weight reduction of the automotive body while maintaining or improving the dynamic stiffness. Then in a manufacturing process of an automotive body, by joining a parts assembly at the obtained optimized joining position, it is possible to improve dynamic stiffness of the automotive body or realize weight reduction of the automotive body while maintaining or improving the dynamic stiffness.

Brief Description of Drawings

FIG. 1 is a block diagram illustrating a configuration of an optimization analysis device of a joining position of an automotive body in a case where four fixed joining points or fixed joining areas according to an embodiment of the present invention are selected.
FIG. 2 is a view illustrating an automotive body model to be analyzed in the embodiment of the present invention and a joining candidate set in a model of the automotive body.
FIG. 3 is a diagram for explaining processing of selecting a first fixed joining point to a fourth fixed joining point that always join a parts assembly in the automotive body model as an example of the embodiment of the present invention.
FIG. 4 is a flowchart illustrating a processing flow of an optimization analysis method of the joining position of the automotive body in a case where the four fixed joining points or fixed joining areas according to the embodiment of the present invention are selected.
FIG. 5 is a diagram illustrating an optimization analysis model used for dynamic analysis for the optimization analysis of the joining position in an example ((a) comparative example 1, (b) comparative example 2, and (c) invention example 1).
FIG. 6 is a diagram illustrating an optimization analysis model during deformation in dynamic analysis for the optimization analysis of the joining position in the example ((a) comparative example 1, (b) comparative example 2, and (c) invention example 1).
FIG. 7 is a diagram illustrating an optimization analysis model after deformation in dynamic analysis for the optimization analysis of the joining position in the example ((a) comparative example 1, (b) comparative example 2, and (c) invention example 1).
FIG. 8 is a diagram illustrating an example of a case where one fixed joining point is selected for each parts assembly according to a conventional technique.
FIG. 9 is a diagram illustrating an example of a case where four fixed joining points are selected for each parts assembly without applying the present invention. Description of Embodiments

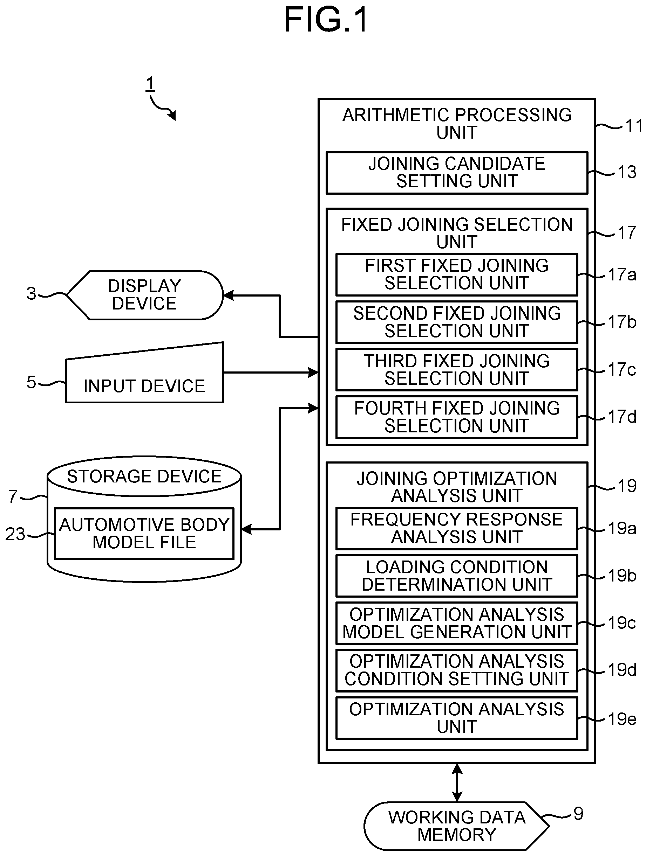

An optimization analysis method and device of a joining position of an automotive body according to an embodiment of the present invention will be described below with reference to FIGS. 1 to 4. Note that, prior to the description of the optimization analysis method and device of the joining position of the automotive body, the target automotive body model in the present invention will be described. The joining point is a spot welding point, and the joining area is a portion continuously welded by laser beam welding, electric arc welding, or the like. In the following description, the case of the joining point will be mainly described as an example. However, the present invention can also be applied to the case of a joining area.

<Automotive body model>

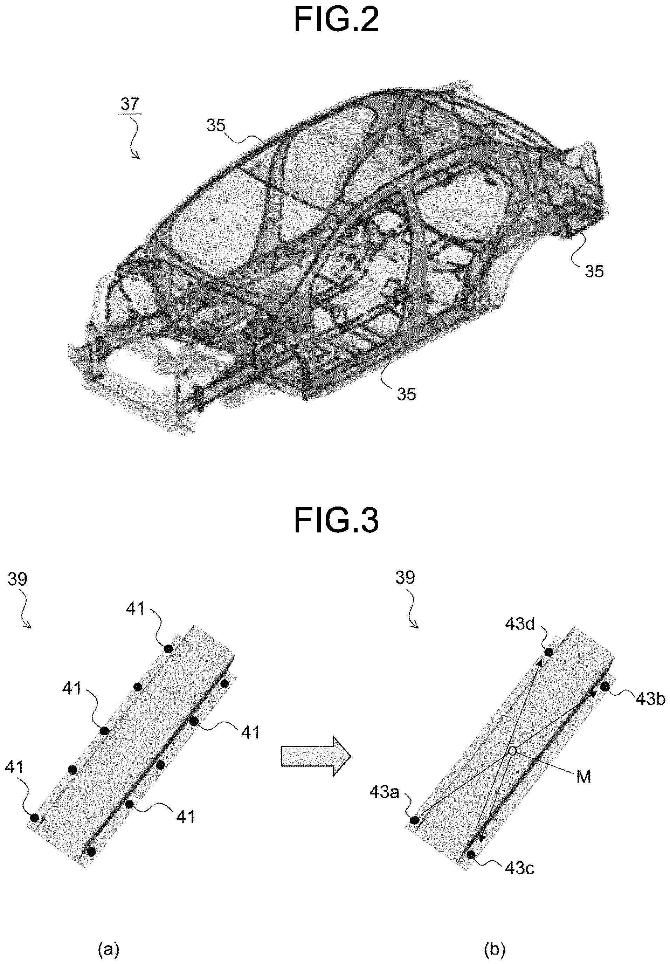

The automotive body model used in the present invention includes a plurality of parts, and the plurality of parts are joined as a parts assembly by a joining point or a joining area. The plurality of parts are automotive body frame parts, chassis parts, or the like.
An example of an automotive body model 37 is illustrated in FIG. 2. Each part in the automotive body model 37 is modeled using a two-dimensional element and/or a three-dimensional element, and a fixed joining point is set at a position where each part is joined as a parts assembly by spot welding.
Since the automotive body model 37 analyzes a deformation behavior, a vibration behavior, or the like generated by the action of a load, each part in the automotive body model 37 is modeled as an elastic body, a viscoelastic body, or an elastoplastic body. Then, material properties and element information of each component constituting the automotive body model 37, and further, information regarding each parts assembly are stored in an automotive body model file 23 (see FIG. 1) to be described later.

<Optimization analysis device of joining position of automotive body>

An optimization analysis device 1 according to the present embodiment (hereinafter, it is simply referred to as an "optimization analysis device 1") performs optimization analysis for obtaining an optimized position of point joining or continuous joining used for joining of each parts assembly for the automotive body model 37. As illustrated in FIG. 1, the optimization analysis device 1 includes a personal computer (PC) or the like, and includes a display device 3, an input device 5, a storage device 7, a working data memory 9, and an arithmetic processing unit 11. Then, the display device 3, the input device 5, the storage device 7, and the working data memory 9 are connected to the arithmetic processing unit 11, and the respective functions are executed by a command from the arithmetic processing unit 11.

Hereinafter, the function of each component of the optimization analysis device 1 according to the present embodiment will be described based on an example of obtaining a fixed joining point for joining a parts assembly and an additional optimized joining point in the automotive body model 37 using the automotive body model 37 illustrated in FIG. 2.

<<Display device>>

The display device 3 is used to display an analysis result or the like, and includes a liquid crystal monitor (LCD monitor) or the like.

<<Input device>>

The input device 5 is used for a display instruction of the automotive body model file 23, an input by an operator, or the like, and includes a keyboard, a mouse, or the like.

<<Storage device>>

The storage device 7 is used for storing various files such as the automotive body model file 23, and includes a hard disk or the like.

<<Working data memory>>

The working data memory 9 is used for temporary storage and calculation of data used by the arithmetic processing unit 11, and includes a random access memory (RAM) or the like.

<<Arithmetic processing unit>>

As illustrated in FIG. 1, the arithmetic processing unit 11 includes a joining candidate setting unit 13, a fixed joining selection unit 17, and a joining optimization analysis unit 19, and includes a central processing unit (CPU) such as a PC. Each of these units functions when the CPU executes a predetermined program. Hereinafter, functions of each unit of the arithmetic processing unit 11 will be described.

(Joining candidate setting unit)

The joining candidate setting unit 13 sets a joining candidate at a position that is a candidate for joining each parts assembly in the automotive body model 37.

An example of specific processing by the joining candidate setting unit 13 is as follows. As illustrated in FIG. 2, joining candidates 35 are densely generated at predetermined intervals in a parts assembly (not illustrated) formed by joining a plurality of parts constituting the automotive body model 37.

(Fixed joining selection unit)

The fixed joining selection unit 17 selects, for each parts assembly of the automotive body model 37, four or more fixed joining points or fixed joining areas to be necessarily joined for each parts assembly from among the joining candidates set for each parts assembly. FIG. 1 illustrates the case of four fixed joining points or fixed joining area. The fixed joining selection unit 17 includes a first fixed joining selection unit 17a, a second fixed joining selection unit 17b, a third fixed joining selection unit 17c, and a fourth fixed joining selection unit 17d. In a case where five or more fixed joining points or fixed joining areas are selected, a fifth fixed joining selection unit or the like may be further added to the arithmetic processing unit.

The fixed joining point or the fixed joining area selected by the fixed joining selection unit 17 is a joining point or a joining area that always joins each parts assembly without being a target of optimization analysis of a joining position to be described later. Then, as preprocessing of optimization analysis, by selecting four fixed joining points or fixed joining areas for each parts assembly by the first fixed joining selection unit 17a to the fourth fixed joining selection unit 17d, optimization analysis of a joining position can be appropriately performed.

Hereinafter, processing of selecting a first fixed joining point 43a, a second fixed joining point 43b, a third fixed joining point 43c, and a fourth fixed joining point 43d from joining candidates 41 will be described using a parts assembly 39 illustrated in FIG. 3 as an example. Note that, in a case where five or more fixed joining points are obtained, a joining candidate farthest from all of the first to fourth fixed joining points may be selected. In addition, a joining candidate that does not overlap the first to fourth fixed joining points may be selected, and the joining candidate may be obtained from among the joining candidates in the same manner as the first to fourth fixed joining points described below.

[First fixed joining selection unit]

The first fixed joining selection unit 17a performs static analysis or dynamic analysis on the automotive body model 37 in which the joining candidates 41 are set for each parts assembly 39, and selects the first fixed joining point 43a from the joining candidates 41 in each parts assembly 39 based on the result of the static analysis or dynamic analysis.

The static analysis is to obtain displacement, a load, or the like generated in a structural body model when a loading condition under which a constant load acts on a predetermined position of the structure model is applied. In the present embodiment, as the static analysis, for example, simple structural analysis (stiffness analysis or the like) for applying a loading condition for applying a static load to the structural body model, or topology optimization to be described later can be applied.

For example, in a case where the first fixed joining point 43a is selected based on the result of the simple structural analysis, first, stress, strain, strain energy, load, or the like are calculated for each of the joining candidates 41 in each parts assembly 39. Next, the joining candidates 41 in each parts assembly 39 are ranked based on these calculated values, and the joining candidate 41 having the highest rank is selected as the first fixed joining point 43a in the parts assembly 39.

For example, in the case based on the strain energy, the joining candidate 41 having the largest strain energy in each parts assembly may be selected as the first fixed joining point 43a. In addition, in the case of the stress, the joining candidate 41 having the largest resultant force of the tensile stress and the shear stress in each parts assembly may be selected as the first fixed joining point 43a. Then, the first fixed joining selection unit 17a can appropriately select the first fixed joining point 43a regardless of strain energy, stress (resultant force of the tensile stress and the shear stress), or the like.

In addition, the first fixed joining point 43a may be selected based on the result of topology optimization. For example, topology optimization may be performed by setting a design variable (for example, density) to each of the joining candidates 41, and ranking of the joining candidates 41 in each parts assembly 39 and selection of the first fixed joining point 43a may be performed based on the value of the design variable obtained for each of the joining candidates 41.

Meanwhile, the dynamic analysis is to obtain vibration characteristics when a periodic load acts on a structural body model, and examples include frequency response analysis, eigenvalue analysis, transient characteristic analysis, or the like.

Then, as dynamic analysis for obtaining the first fixed joining point 43a, for example, even in a case where frequency response analysis is performed, stress, strain, strain energy, load, or the like are calculated for each of the joining candidates 41 similarly to the case of the above-described simple structural analysis, and the first fixed joining point 43a is selected based on the calculated values.

However, since the value of the strain energy or the like in each of the joining candidates 41 calculated by the frequency response analysis is a periodically varying value, the ranking of the joining candidates may be performed based on, for example, a peak value of the strain energy or the like.

[Second fixed joining selection unit]

For each parts assembly 39, the second fixed joining selection unit 17b selects, as the second fixed joining point 43b, the joining candidate 41 having a farthest distance from the first fixed joining point 43a among the joining candidates 41.

[Third fixed joining selection unit]

The third fixed joining selection unit 17c selects, as the third fixed joining point 43c, the joining candidate 41 having a farthest distance from a midpoint M of the straight line connecting the first fixed joining point 43a and the second fixed joining point 43b from the joining candidates 41 excluding the first fixed joining point 43a and the second fixed joining point 43b for each parts assembly 39.

[Fourth fixed joining selection unit]

The fourth fixed joining selection unit 17d selects, as the fourth fixed joining point 43d, the joining candidate 41 having a farthest distance from the third fixed joining point 43c from the joining candidates 41 excluding the first fixed joining point 43a and the second fixed joining point 43b for each parts assembly 39.

Note that it is preferable that the second fixed joining selection unit 17b, the third fixed joining selection unit 17c, and the fourth fixed joining selection unit 17d calculate the distances for the joining candidates 41 in each parts assembly 39 in a round-robin manner. In the calculation of the distance, for example, a coordinate value of a center point obtained from node coordinates of an element set as the joining candidate 41 or an element selected as the first to third fixed joining points 43a to 43c may be used.

In addition, in the selection of the third fixed joining point 43c by the third fixed joining selection unit 17c, the coordinates of the midpoint M may be calculated using the coordinates of the representative points of the first fixed joining point 43a and the second fixed joining point 43b.

Furthermore, in a case where the fifth fixed joining point is selected, a joining candidate farthest from all of the first to fourth fixed joining points may be selected. For example, the distance from the first to fourth fixed joining points may be calculated to select the farthest joining candidate in a round-robin manner, or the midpoint of the first to fourth fixed joining points may be obtained to select the joining candidate farthest from the midpoint. Alternatively, similarly to the case of selecting the first fixed joining point described above, the fifth fixed joining point may be selected from the joining candidates 41 excluding the first to fourth fixed joining points based on the result of the static analysis or the dynamic analysis.

In addition, in a case where the sixth fixed joining point is selected, similarly to the case of selecting the second fixed joining point, the joining candidate having a farthest distance from the fifth fixed joining point may be selected as the sixth fixed joining point from the joining candidates excluding the first to fifth fixed joining point.

Note that, when the sixth or more fixed joining points are selected and the joining points are fixed, the number of remaining joining candidates to be optimized is significantly reduced, and the effect of improving the stiffness of the entire automotive body while optimizing the joining points or the joining areas to reduce the joining amount to be joined as much as possible is diminished. Therefore, it is effective for achieving the original purpose to keep the selection of fixed joining points to the fifth fixed joining point.

(Joining optimization analysis unit)

The joining optimization analysis unit 19 generates an optimization analysis model (not illustrated) in which the first fixed joining point to the fourth fixed joining point selected for each parts assembly by the fixed joining selection unit 17 and an optimal joining candidate to be an optimization analysis target are set in the automotive body model. Then, the joining optimization analysis unit 19 performs optimization analysis to obtain an optimized joining point or joining area for joining the parts assembly in the optimization analysis model.

In the present embodiment, as illustrated in FIG. 1, the joining optimization analysis unit 19 includes a frequency response analysis unit 19a, a loading condition determination unit 19b, an optimization analysis model generation unit 19c, an optimization analysis condition setting unit 19d, and an optimization analysis unit 19e.

[Frequency response analysis unit]

The frequency response analysis unit 19a applies a predetermined excitation condition to a fixed joining setting automotive body model (not illustrated) in which a first fixed joining point to a fourth fixed joining point are set for each parts assembly to perform frequency response analysis, and obtains a vibration mode generated in the fixed joining setting automotive body model and a deformation state in the vibration mode.

The frequency response analysis is a type of dynamic analysis, and is an analysis method for obtaining a vibration mode representing a response such as displacement of a structural body when an excitation condition for inputting a stationary sine wave load to the structural body is applied, and a deformation state in the vibration mode. Then, as an excitation condition in the frequency response analysis, for example, a sine wave load is input to the right and left rear suspension attachment portions of the fixed joining setting automotive body model in the automotive body upward direction.

[Loading condition determination unit]

The loading condition determination unit 19b determines the loading condition to be applied to the fixed joining setting automotive body model corresponding to the deformation state in the vibration mode obtained by the frequency response analysis unit 19a. Then, the deformation state in the vibration mode may be, for example, a deformation of the fixed joining setting automotive body model at a time point when the total displacement of the fixed joining setting automotive body model becomes maximum.

[Optimization analysis model generation unit]

The optimization analysis model generation unit 19c generates an optimization analysis model by setting the first fixed joining point to the fourth fixed joining point and an optimal joining candidate to be an optimization analysis target in the automotive body model.

In the present embodiment, the optimization analysis model generation unit 19c sets the joining candidate 35 set in the automotive body model 37 as an optimal joining candidate. However, the first fixed joining point to the fourth fixed joining point (up to the fifth fixed joining point in some cases) selected by the fixed joining selection unit 17 are excluded from the optimal joining candidates.

[Optimization analysis condition setting unit]

The optimization analysis condition setting unit 19d sets an optimization analysis condition for performing an optimization analysis in which an optimal joining candidate in an optimization analysis model generated by the optimization analysis model generation unit 19c is an optimization target.

Two types of optimization analysis conditions, which are an objective and a constraint, are set. The objective is an optimization analysis condition set according to the purpose of the optimization analysis, and includes, for example, minimizing strain energy, maximizing absorbed energy to minimize generated stress, or the like. Only one objective is set. The constraint is a constraint imposed in performing the optimization analysis, and for example, the optimization analysis model is set to have predetermined stiffness. A plurality of constraints can be set.

[Optimization analysis unit]

The optimization analysis unit 19e applies the loading condition determined by the loading condition determination unit 19b to the optimization analysis model to perform optimization analysis, and obtains an optimal joining candidate that satisfies the optimization analysis condition set by the optimization analysis condition setting unit 19d as an optimized joining point or joining area that joins each parts assembly.

Note that topology optimization can be applied to the optimization analysis by the optimization analysis unit 19e. Then, in a case where the intermediate density is large when the densimetry is used in the topology optimization, it is preferable to perform discretization as represented by Formula (1).

$$K'(\rho) = \rho^{P}K$$

where

K' : stiffness matrix in which penalty is imposed on stiffness matrix of element
K: stiffness matrix of element
$\rho$: normalized density
p: penalty coefficient

The penalty coefficient often used for discretization is 2 or more, but in the optimization of the joining position according to the present invention, the penalty coefficient is preferably 4 or more.

Note that the optimization analysis unit 19e may perform optimization processing by topology optimization, or may perform optimization processing by another calculation method. Then, as the optimization analysis unit 19e, for example, optimization analysis software using a commercially available finite element method can be used.

In addition, in the optimization analysis by the optimization analysis unit 19e, an inertial force acting at the time of traveling of the automobile by an inertia relief method may be considered. The inertia relief method is an analysis method for obtaining stress and strain from a force acting on an object during constant acceleration motion in a state where the object is supported at a support point serving as a reference of coordinates of inertial force (free support), and is used for static analysis of an airplane or a ship in motion.

<Optimization analysis method of joining position of automotive body>

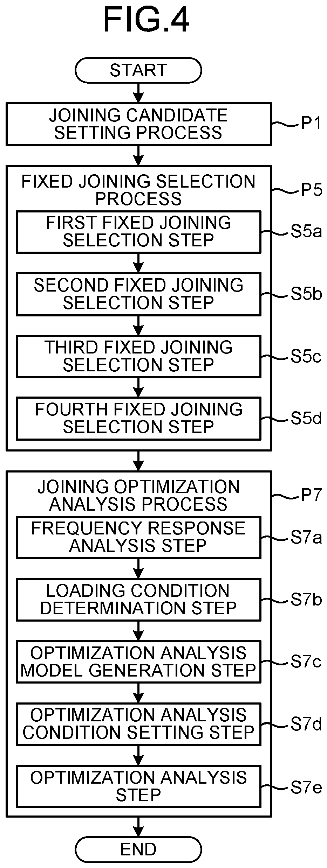

An optimization analysis method of a joining position of an automotive body according to an embodiment of the present invention (hereinafter, it is simply referred to as an "optimization analysis method") performs optimization analysis for obtaining an optimized position of point joining or continuous joining used for joining of each parts assembly for the automotive body model 37 of an automobile (FIG. 2). The optimization analysis method includes a joining candidate setting process P1, a fixed joining selection process P5, and a joining optimization analysis process P7 as illustrated in FIG. 4 as an example up to the fourth fixed joining selection step. Each of these processes will be described below. Note that each process is performed by the optimization analysis device 1 (FIG. 1) including a computer.

<<Joining candidate setting process>>

The joining candidate setting process P1 sets a joining candidate at a position that is a candidate for joining each parts assembly in the automotive body model 37, and is performed by the joining candidate setting unit 13 in the optimization analysis device 1 illustrated in FIG. 1.

<<Fixed joining selection process>>

The fixed joining selection process P5 selects, for each parts assembly of the automotive body model 37, four or more fixed joining points or fixed joining areas to be necessarily joined for each parts assembly from among the joining candidates set for each parts assembly, and is performed by the fixed joining selection unit 17 in the optimization analysis device 1 illustrated in FIG. 1.

Then, as illustrated in FIG. 4, the fixed joining selection process P5 includes a first fixed joining selection step S5a, a second fixed joining selection step S5b, a third fixed joining selection step S5c, and a fourth fixed joining selection step S5d. Note that fifth and subsequent fixed joining selection steps may be included.

(First fixed joining selection step)

The first fixed joining selection step S5a performs static analysis or dynamic analysis on the automotive body model 37, selects the first fixed joining point 43a from the joining candidates 41 in each parts assembly 39 based on the result of the static analysis or dynamic analysis as illustrated in FIG. 3, and is performed by the first fixed joining selection unit 17a in the optimization analysis device 1 illustrated in FIG. 1.

In first fixed joining selection step S5a, for example, simple structural analysis, topology optimization, or the like can be applied as the static analysis, and for example, frequency response analysis or the like can be applied as the dynamic analysis.

For example, in a case where simple structural analysis is performed as static analysis, first, stress, strain, strain energy, load, or the like are calculated for each of the joining candidates 41 in each parts assembly 39. Next, the joining candidates 41 in each parts assembly 39 are ranked based on the magnitudes of these calculated values, and the joining candidate 41 having the highest rank is selected as the first fixed joining point 43a in the parts assembly 39 (see FIG. 3).

On the other hand, in a case where the frequency response analysis is performed as the dynamic analysis, similarly to the simple structural analysis, peak values of stress, strain, strain energy, load, or the like are obtained for each of the joining candidates 41, and the joining candidates 41 in each parts assembly 39 are ranked based on the obtained values to select the first fixed joining point 43a (see FIG. 3).

(Second fixed joining selection step)

As illustrated in FIG. 3, the second fixed joining selection step S5b selects, as the second fixed joining point 43b, the joining candidate 41 having a farthest distance from the first fixed joining point 43a among the joining candidates 41 for each parts assembly 39, and is performed by the second fixed joining selection unit 17b in the optimization analysis device 1 illustrated in FIG. 1.

(Third fixed joining selection step)

As illustrated in FIG. 3, the third fixed joining selection step S5c selects, as the third fixed joining point 43c, the joining candidate 41 having a farthest distance from a midpoint M of the straight line connecting the first fixed joining point 43a and the second fixed joining point 43b from the joining candidates 41 excluding the first fixed joining point 43a and the second fixed joining point 43b for each parts assembly 39. The third fixed joining selection step S5c is performed by the third fixed joining selection unit 17c in the optimization analysis device 1 illustrated in FIG. 1.

(Fourth fixed joining selection step)

As illustrated in FIG. 3, the fourth fixed joining selection step S5d selects, as the fourth fixed joining point 43d, the joining candidate 41 having a farthest distance from the third fixed joining point 43c from the joining candidates 41 excluding the first fixed joining point 43a and the second fixed joining point 43b for each parts assembly 39. The fourth fixed joining selection step S5d is performed by the fourth fixed joining selection unit 17d in the optimization analysis device 1 illustrated in FIG. 1.

Furthermore, in a case where the fifth fixed joining point is selected, a joining candidate farthest from all of the first to fourth fixed joining points may be selected. For example, the distance from the first to fourth fixed joining points may be calculated to select the farthest joining candidate in a round-robin manner, or the midpoint of the first to fourth fixed joining points may be obtained to select the joining candidate farthest from the midpoint. Alternatively, similarly to the first fixed joining selection step S5a described above, the fifth fixed joining point may be selected from the joining candidates 41 excluding the first to fourth fixed joining points based on the result of the static analysis or the dynamic analysis.

In addition, in a case where the sixth fixed joining point is selected, similarly to the second fixed joining selection step S5b described above, the joining candidate having a farthest distance from the fifth fixed joining point may be selected as the sixth fixed joining point from the joining candidates excluding the first to fifth fixed joining point.

Note that, when the sixth or more fixed joining points are selected and the joining points are fixed, the number of remaining joining candidates to be optimized is significantly reduced, and the effect of improving the stiffness of the entire automotive body while optimizing the joining points or the joining areas to reduce the joining amount to be joined as much as possible is diminished. Therefore, it is effective for achieving the original purpose to keep the selection of fixed joining points to the fifth fixed joining point.

Note that it is preferable that the second fixed joining selection step S5b, the third fixed joining selection step S5c, the fourth fixed joining selection step S5d, or the like calculate the distances for the joining candidates 41 in each parts assembly 39 in a round-robin manner.

<<Joining optimization analysis process>>

The joining optimization analysis process P7 generates an optimization analysis model (not illustrated) in which the first fixed joining point to the fourth fixed joining point selected for each parts assembly in the fixed joining selection process P5 and an optimal joining candidate to be an optimization analysis target are set in the automotive body model, and performs optimization analysis to obtain an optimized joining point or joining area for joining the parts assembly in the optimization analysis model. The joining optimization analysis process P7 is performed by the joining optimization analysis unit 19 in the optimization analysis device 1 illustrated in FIG. 1.

In the present embodiment, as illustrated in FIG. 4, the joining optimization analysis process P7 includes a frequency response analysis step S7a, a loading condition determination step S7b, an optimization analysis model generation step S7c, an optimization analysis condition setting step S7d, and an optimization analysis step S7e.

(Frequency response analysis step)

The frequency response analysis step S7a applies a predetermined excitation condition to a fixed joining setting automotive body model (not illustrated) in which a first fixed joining point to a fourth fixed joining point are set for each parts assembly to perform frequency response analysis, and obtains a vibration mode generated in the fixed joining setting automotive body model and a deformation state in the vibration mode. The frequency response analysis step S7a is performed by the frequency response analysis unit 19a in the optimization analysis device 1 illustrated in FIG. 1.

(Loading condition determination step)

The loading condition determination step S7b determines the loading condition to be applied to the fixed joining setting automotive body model corresponding to the deformation state in the vibration mode obtained in the frequency response analysis step S7a, and is performed by the loading condition determination unit 19b in the optimization analysis device 1 illustrated in FIG. 1. In determining the loading condition in the loading condition determination step S7b, the deformation state in the vibration mode may be, for example, a deformation of the fixed joining setting automotive body model at a time point when the total displacement of the fixed joining setting automotive body model becomes maximum.

(Optimization analysis model generation step)

The optimization analysis model generation step S7c generates an optimization analysis model (not illustrated) in which the first fixed joining point to the fourth fixed joining point and the optimal joining candidate to be the target of the optimization analysis are set in the automotive body model, and is performed by the optimization analysis model generation unit 19c in the optimization analysis device 1 illustrated in FIG. 1.

Then, the optimization analysis model generation step S7c sets the joining candidate 35 set in the automotive body model 37 as an optimal joining candidate. However, the first fixed joining point to the fourth fixed joining point (up to the fifth fixed joining point in some cases) selected in the fixed joining selection process P5 are excluded from the optimal joining candidates.

(Optimization analysis condition setting step)

The optimization analysis condition setting step S7d sets an optimization analysis condition for performing an optimization analysis in which an optimal joining candidate in an optimization analysis model generated by the optimization analysis model generation step S7c is an optimization target, and is performed by the optimization analysis condition setting unit 19d in the optimization analysis device 1 illustrated in FIG. 1.

Two types of optimization analysis conditions, which are an objective and a constraint, are set. The objective is an optimization analysis condition set according to the purpose of the optimization analysis, and includes, for example, minimizing strain energy, maximizing absorbed energy to minimize generated stress, or the like. Only one objective is set. The constraint is a constraint imposed in performing the optimization analysis, and for example, the optimization analysis model is set to have predetermined stiffness. A plurality of constraints can be set.

(Optimization analysis step)

The optimization analysis step S7e applies the loading condition determined in the loading condition determination step S7b to the optimization analysis model to perform optimization analysis, and obtains an optimal joining candidate that satisfies the optimization analysis condition set in the optimization analysis condition setting step S7d as an optimized joining point or joining area that joins each parts assembly.

Topology optimization can be applied to the optimization analysis in the optimization analysis step S7e. Then, in a case where the intermediate density is large when the densimetry is used in the topology optimization, it is preferable to perform discretization as represented by the above-described Formula (1).

Note that the optimization analysis step S7e may perform optimization processing by topology optimization, or may perform optimization processing by another calculation method. Then, the optimization processing in the optimization analysis step S7e can be performed using, for example, optimization analysis software using a commercially available finite element method.

Furthermore, in the optimization analysis in the optimization analysis step S7e, the inertial force acting on the optimization analysis model may be considered by the inertial relief method.

As described above, according to the optimization analysis method and device of the joining position of the automotive body according to the embodiment of the present invention, four or more fixed joining points or fixed joining areas are appropriately set for each parts assembly also in the dynamic analysis for the optimization analysis of the joining position. Therefore, it is possible to suppress flapping between parts and deviation or separation in dynamic analysis for optimization analysis of a joining position, and it is possible to obtain an optimized joining position for improvement of dynamic stiffness of an automotive body or weight reduction of the automotive body while maintaining the dynamic stiffness.

In addition, in the above description, as illustrated in FIG. 3, the first fixed joining point 43a to the fourth fixed joining point 43d are selected for each parts assembly 39 and subjected to the optimization analysis. However, in the present invention, five or more fixed joining points may be selected and subjected to the optimization analysis.

In a case where the fifth fixed joining point is selected, a joining candidate farthest from all of the first to fourth fixed joining points may be selected. Alternatively, the fifth fixed joining point may be selected from the joining candidates excluding the first to fourth fixed joining points based on the result of the static analysis or the dynamic analysis. Furthermore, as the fifth fixed joining point, for example, a midpoint on a straight line connecting the third fixed joining point and the fourth fixed joining point is obtained, and a joining candidate having a farthest distance from the midpoint may be selected as the fifth fixed joining point from among the joining candidates excluding the already selected fixed joining point. Alternatively, distances from the first to fourth fixed joining points may be calculated to select the farthest joining candidate in a round-robin manner. The sixth and subsequent fixed joining points can also be selected by repeating the same procedure as the fifth fixed joining point.

Note that, when the sixth or more fixed joining points are selected and the joining points are fixed, the number of remaining joining candidates to be optimized is significantly reduced, and the effect of improving the stiffness of the entire automotive body while optimizing the joining points or the joining areas to reduce the joining amount to be joined as much as possible is diminished. Therefore, it is effective for achieving the original purpose to keep the selection of fixed joining points to the fifth fixed joining point.

Note that, in the above description, the case where the joining candidates 35 are automatically generated at predetermined intervals has been described, but the present invention is not limited to this, and for example, the joining candidates 35 may be generated manually by the operator using the input device 5.

In addition, in the above description, the fixed joining points joined by spot welding are generated in the automotive body model 37. However, in the present invention, the fixed joining areas continuously joined by laser beam welding, electric arc welding, or the like may be generated in the automotive body model 37.

Then, in a case where the fixed joining area is selected for each parts assembly using such an automotive body model, it is possible to obtain a representative point of the joining area by using the node coordinates of one or a plurality of two-dimensional element or three-dimensional element constituting each joining area, and to calculate a distance from another joining candidate or an already selected fixed joining point or fixed joining area.

Furthermore, the optimization analysis method and device of the joining position of the automotive body according to the present embodiment obtain the deformation state in the vibration mode generated in the fixed joining setting automotive body model by performing the frequency response analysis which is the dynamic analysis when determining the loading condition in the optimization analysis. However, in the present invention, the eigenvalue analysis may be applied as the dynamic analysis instead of the frequency response analysis to obtain the deformation state in the vibration mode generated in the fixed joining setting automotive body model.

The eigenvalue analysis is an analysis method for obtaining a characteristic frequency and an eigenmode (mode of vibration) which are vibrational characteristics of the structural body. Then, in the eigenvalue analysis, since the vibration characteristics are merely obtained, it is possible to obtain the deformation state in the vibration mode without requiring the excitation condition.

Examples

Since the analysis for confirming the effect of the present invention has been performed, this will be described below. In the present example, using the automotive body model 37 (FIG. 2) in which a plurality of parts is joined by joining points as a parts assembly, optimized joining points to be joined for improving dynamic stiffness were obtained by optimization analysis.

First, four or five fixed joining points were selected for each parts assembly of the automotive body model 37 by the following method. As illustrated in FIG. 2, dynamic analysis was performed on the automotive body model 37 in which the joining candidates 35 are set, and a peak value of strain energy was calculated for each of the joining candidates 35. In this example, frequency response analysis was applied as dynamic analysis for selecting a fixed joining point.

Then, for each parts assembly, the joining candidates 35 having the largest peak value of strain energy was selected as the first fixed joining point. After the selection of the first fixed joining point, for each parts assembly, the second fixed joining point to the fourth fixed joining point or the fifth fixed joining point were selected in order according to the procedure described in the embodiment. In the selection of the second fixed joining point to the fourth fixed joining point or the fifth fixed joining point, the distance was calculated in a round-robin manner for the joining candidate of each parts assembly.

Next, using four or more fixed joining points selected for each parts assembly, optimization analysis of a joining position at which each parts assembly is joined was performed.

In performing the optimization analysis, first, a dynamic analysis of a fixed joining setting automotive body model in which a fixed joining point is set was performed, and a deformation state in a vibration mode generated in the fixed joining setting automotive body model was obtained. In the present example, eigenvalue analysis was performed as dynamic analysis for obtaining a deformation state in a vibration mode.

Then, the loading condition to be applied to the fixed joining setting automotive body model corresponding to the deformation state in the vibration mode was determined. Here, a loading condition corresponding to a deformation state to be a torsional mode, which is one of vibration modes, was determined.

Subsequently, the joining candidates of the automotive body model 37 were densely generated at predetermined intervals (10 mm) to be optimal joining candidates.

Then, an optimization analysis model in which the fixed joining point and the optimal joining candidate were set in the automotive body model was generated, and optimization analysis of the joining position was performed. In the optimization analysis, topology optimization was applied, and each of the objective and the constraint, which are optimization analysis conditions, was set in the optimization analysis model. In the present example, the objective is the minimization of compliance (the maximization of stiffness), and the constraint is the ratio (number) of joining candidates to be left.

Furthermore, an optimization analysis was performed by applying a loading condition obtained by performing a dynamic analysis to the optimization analysis model, and an optimal joining candidate satisfying the optimization analysis condition was obtained as an optimized joining point. In addition, in the optimization analysis, the number of optimized joining points was 3949.

In the present embodiment, four or five fixed joining points are selected for each parts assembly according to the above method, and an optimum joining point is obtained by optimization analysis in which the selected four or five fixed joining points are set. As an invention example, deformation of an automotive body model in dynamic analysis and vibration characteristics of an optimization analysis model in which the optimized joining point obtained by the optimization analysis is set are obtained as follows. Note that, in invention example 1, four fixed joining points are selected and set, and in invention example 2, five fixed joining points are selected and set.

Furthermore, as a comparison object, according to the method described in Patent Literature 2, static analysis (simple structural analysis) of an automotive body model using the joining point as a joining candidate was performed, and one or four fixed joining points were selected based on only the magnitude of strain energy obtained for the joining candidate of each parts assembly, and this was used as a comparative example. Then, in the comparative example, the deformation of the automotive body model by the dynamic analysis and the vibration characteristics were obtained as in the invention example.

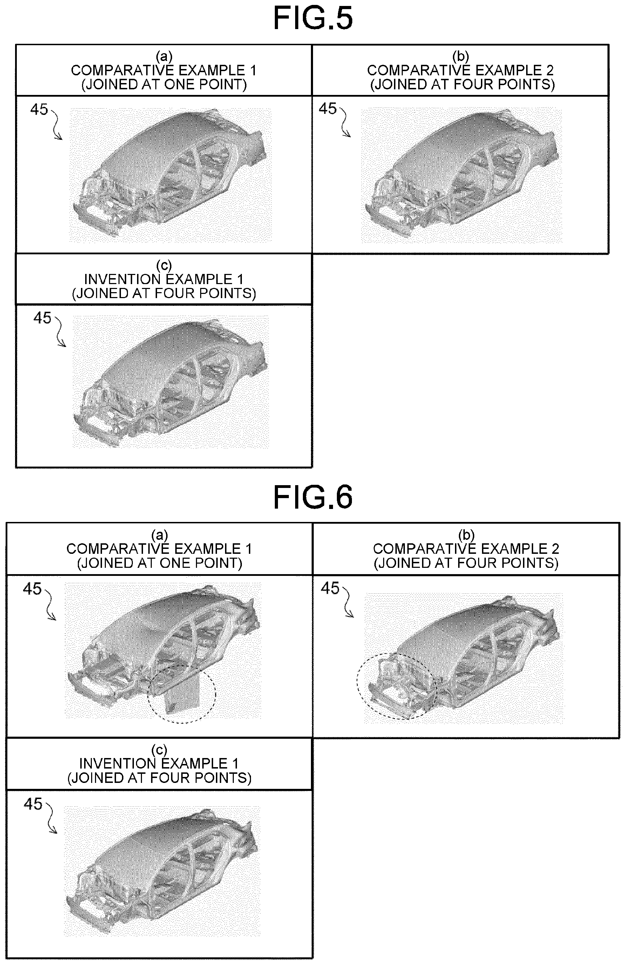

FIGS. 5 to 7 illustrate results of performing dynamic analysis (eigenvalue analysis) using a fixed joining setting automotive body model 45 in which the fixed joining point is set and obtaining a deformation state generated in the fixed joining setting automotive body model 45. FIG. 5 illustrates a shape of the fixed joining setting automotive body model 45 before the deformation starts, FIG. 6 illustrates a shape thereof in the middle of the deformation, and FIG. 7 illustrates a shape thereof after the deformation ends.

In comparative example 1 (FIGS. 5(a), 6(a), and 7(a)), one fixed joining point was set for each parts assembly, flapping occurred in the part as the deformation progressed, and the floor panel (a portion surrounded by broken line ellipses in the drawing) deviated downward from the middle of the deformation. In comparative example 2 (FIGS. 5(b), 6(b), and 7(b)), four fixed joining points are selected for each parts assembly only in the descending order of strain energy. Since the four fixed joining points were uneven on one side of the parts, the parts flapped as the deformation progressed, and some of the parts deviated from the portion where the parts assembly was joined at the end of the deformation (the portion surrounded by the dotted line ellipses in the drawing).

In invention example 1 (FIGS. 5(c), 6(c), and 7(c)), four fixed joining points are set for each parts assembly, but the parts do not flap, do not deviate, and do not become separated, and torsional deformation occurs in the fixed joining setting automotive body model 45.

Next, for each of the invention example and the comparative example, eigenvalue analysis of an optimization analysis model in which optimized joining points obtained by optimization analysis are set was performed to obtain the frequency of the vibration mode to be the torsional mode. The results of obtaining the frequency of the torsional mode are shown in Table 1.

Table 1

|  | Parts assembly fixed joining point | Torsional mode frequency (Hz) |
|---|---|---|
| Comparative example 1 | One point (strain energy) | 30.07 |
| Comparative example 2 | Four points (strain energy) | 33.86 |
| Invention example 1 | Four points (distance) | 33.84 |
| Invention example 2 | Five points (distance) | 33.85 |

As shown in Table 1, the frequencies in comparative example 2, invention example 1, and invention example 2 in which four or five fixed joining points were set in each parts assembly were higher than the frequency (30.07 Hz) in comparative example 1 in which one fixed joining point was set in each parts assembly, and the dynamic stiffness was improved.

However, in comparative example 2 in which four fixed joining points selected from only strain energy were set, as illustrated in FIGS. 5(b) to 7(b), flapping occurred in some parts in the dynamic analysis of the fixed joining setting automotive body model in which the four fixed joining points were set, causing trouble.

On the other hand, in invention example 1 and invention example 2, the frequency of the vibration mode could be appropriately obtained without causing the parts in the dynamic analysis to flap, deviate, or become separated. Furthermore, in invention example 1 and invention example 2, since the frequency of the torsion vibration mode was higher than that in comparative example, the dynamic stiffness was improved.

Industrial Applicability

According to the present invention, it is possible to provide an optimization analysis method and device of a joining position of an automotive body for obtaining an optimized position of a joining point or a joining area at which a parts assembly of the automotive body is joined while preventing flapping, deviation, and separation of the parts assembly and achieving both dynamic stiffness and weight reduction of the automotive body in dynamic analysis for improving dynamic stiffness related to vibration characteristics of the automotive body.

Reference Signs List

1 OPTIMIZATION ANALYSIS DEVICE
3 DISPLAY DEVICE
5 INPUT DEVICE
7 STORAGE DEVICE
9 WORKING DATA MEMORY
11 ARITHMETIC PROCESSING UNIT
13 JOINING CANDIDATE SETTING UNIT
17 FIXED JOINING SELECTION UNIT
17a FIRST FIXED JOINING SELECTION UNIT
17b SECOND FIXED JOINING SELECTION UNIT
17c THIRD FIXED JOINING SELECTION UNIT
17d FOURTH FIXED JOINING SELECTION UNIT
19 JOINING OPTIMIZATION ANALYSIS UNIT
19a FREQUENCY RESPONSE ANALYSIS UNIT
19b LOADING CONDITION DETERMINATION UNIT
19c OPTIMIZATION ANALYSIS MODEL GENERATION UNIT
19d OPTIMIZATION ANALYSIS CONDITION SETTING UNIT
19e OPTIMIZATION ANALYSIS UNIT
23 AUTOMOTIVE BODY MODEL FILE
35 JOINING CANDIDATE
37 AUTOMOTIVE BODY MODEL
39 PARTS ASSEMBLY
41 JOINING CANDIDATE
43 FIXED JOINING POINT
43a FIRST FIXED JOINING POINT
43b SECOND FIXED JOINING POINT
43c THIRD FIXED JOINING POINT
43d FOURTH FIXED JOINING POINT
45 FIXED JOINING SETTING AUTOMOTIVE BODY MODEL
51 PARTS ASSEMBLY
53 FLANGE PORTION
55 JOINING POINT
57 FIXED JOINING POINT

**Claims**

1.  An optimization analysis method of a joining position of an automotive body for performing, by a computer, an optimization analysis of obtaining an optimized position of point joining or continuous joining used for joining of a parts assembly of the automotive body for improving dynamic stiffness related to vibration characteristics of the automotive body of an automobile by performing each of following processes on an automotive body model (37) of an automobile including a plurality of parts and joining the plurality of parts as a parts assembly at a joining point or a joining area, the method comprising:

    a joining candidate setting process of setting a joining candidate at a position that is a candidate for joining the parts assembly;

a fixed joining selection process of selecting four or more fixed joining points or fixed joining areas to be necessarily joined for each parts assembly from among the joining candidates set for each parts assembly; and
a joining optimization analysis process of

setting, in the automotive body model, the fixed joining point or the fixed joining area selected for each parts assembly without being a target of the optimization analysis and an optimal joining candidate to be a target of the optimization analysis, and
performing an optimization analysis of obtaining an optimized joining point or joining area that joins the parts assembly in the automotive body model excluding the fixed joining point or the fixed joining area selected for each parts assembly, wherein

the fixed joining selection process includes:

a first fixed joining selection step of performing a static analysis or a dynamic analysis on the automotive body model in which the joining candidates are set, and selecting a first fixed joining point (43a) or fixed joining area from among the joining candidates for each parts assembly based on a result of the static analysis or the dynamic analysis,
a second fixed joining selection step of selecting a joining candidate having a farthest distance from the first fixed joining point or fixed joining area as a second fixed joining point (43b) or fixed joining area in the parts assembly,
a third fixed joining selection step of selecting a joining candidate having a farthest distance from a midpoint on a straight line connecting the first fixed joining point or fixed joining area and the second fixed joining point or fixed joining area as a third fixed joining point (43c) or fixed joining area, and
a fourth fixed joining selection step of selecting a joining candidate having a farthest distance from the third fixed joining point or joining area among the joining candidates excluding the first fixed joining point or fixed joining area and the second fixed joining point or fixed joining area as a fourth fixed joining point (43d) or fixed joining area,

wherein the plurality of parts are joined as the parts assembly of the automotive body at the first, second, third and fourth fixed joining points or at the first, second, third and fourth fixed joining areas.

2. The optimization analysis method of a joining position of an automotive body according to claim 1, wherein in the first fixed joining selection step of the fixed joining selection process, a joining candidate having a largest strain energy is selected as the first fixed joining point or fixed joining area.

3. The optimization analysis method of a joining position of an automotive body according to claim 1, wherein in the first fixed joining selection step of the fixed joining selection process, a joining candidate having a largest resultant force of a tensile stress and a shear stress is selected as the first fixed joining point or fixed joining area.

4. The optimization analysis method of a joining position of an automotive body according to according to any one of claims 1 to 3, wherein in the fixed joining selection process, a center of the joining candidate is set as a representative point, and the distance is calculated in a round-robin manner for the joining candidate in each parts assembly.

5. An optimization analysis device which includes a computer of a joining position of an automotive body for performing an optimization analysis of obtaining an optimized position of point joining or continuous joining used for joining of a parts assembly on an automotive body model of an automobile including a plurality of parts and joining the plurality of parts as a parts assembly at a joining point or a joining area, the device comprising:

a joining candidate setting unit configured to set a joining candidate at a position that is a candidate for joining the parts assembly;
a fixed joining selection unit configured to select four or more fixed joining points or fixed joining areas to be necessarily joined for each parts assembly from among the joining candidates set for each parts assembly; and
a joining optimization analysis unit configured to

set, in the automotive body model, the fixed joining point or the fixed joining area selected for each parts assembly without being a target of the optimization analysis and an optimal joining candidate to be a target of the optimization analysis, and
perform an optimization analysis of obtaining an optimized joining point or joining area that joins the parts assembly in the automotive body model excluding the fixed joining point or the fixed joining area selected for each parts assembly, wherein

the fixed joining selection unit includes:

a first fixed joining selection unit configured to perform a static analysis or a dynamic analysis on the automotive body model in which the joining candidates are set, and selecting a first fixed joining point or fixed joining area from among the joining candidates for each parts assembly based on a result of the static analysis or the dynamic analysis,

a second fixed joining selection unit configured to select a joining candidate having a farthest distance from the first fixed joining point or fixed joining area as a second fixed joining point or fixed joining area in the parts assembly,

a third fixed joining selection unit configured to select a joining candidate having a farthest distance from a midpoint on a straight line connecting the first fixed joining point or fixed joining area and the second fixed joining point or fixed joining area as a third fixed joining point or fixed joining area, and

a fourth fixed joining selection unit configured to select a joining candidate having a farthest distance from the third fixed joining point or joining area among the joining candidates excluding the first fixed joining point or fixed joining area and the second fixed joining point or fixed joining area as a fourth fixed joining point or fixed joining area.

6. The optimization analysis device of a joining position of an automotive body according to claim 5, wherein in the first fixed joining selection unit of the fixed joining selection unit, a joining candidate having a largest strain energy is selected as the first fixed joining point or fixed joining area.

7. The optimization analysis device of a joining position of an automotive body according to claim 5, wherein in the first fixed joining selection unit of the fixed joining selection unit, a joining candidate having a largest resultant force of a tensile stress and a shear stress is selected as the first fixed joining point or fixed joining area.

8. The optimization analysis device of a joining position of an automotive body according to according to any one of claims 5 to 7, wherein in the fixed joining selection unit, a center of the joining candidate is set as a representative point, and the distance is calculated in a round-robin manner for the joining candidate in each parts assembly.

**Patentansprüche**

1. Optimierungsanalyseverfahren einer Verbindungsposition einer Kraftfahrzeugkarosserie zum Durchführen einer Optimierungsanalyse durch einen Computer, um eine optimierte Position einer Punktverbindung oder einer kontinuierlichen Verbindung zu erhalten, die zum Verbinden einer Teilebaugruppe der Kraftfahrzeugkarosserie verwendet wird, um die dynamische Steifigkeit in Bezug auf die Schwingungseigenschaften der Kraftfahrzeugkarosserie eines Kraftfahrzeugs zu verbessern, indem jeder der folgenden Prozesse an einem Kraftfahrzeugkarosseriemodell (37) eines Kraftfahrzeugs, das eine Vielzahl von Teilen enthält, durchgeführt wird und die Vielzahl von Teilen als eine Teilebaugruppe an einem Verbindungspunkt oder einem Verbindungsbereich verbunden wird, wobei das Verfahren umfasst:

einen Fügekandidaten-Einstellprozess zum Einstellen eines Fügekandidaten an einer Position, die ein Kandidat für das Fügen der Teilebaugruppe ist;

einen Festverbindungsauswahlprozess des Auswählens von vier oder mehr Festverbindungspunkten oder Festverbindungsbereichen, die notwendigerweise für jede Teilebaugruppe zu verbinden sind, aus den für jede Teilebaugruppe eingestellten Verbindungskandidaten; und

einen Fügeoptimierungs-Analyseprozess zum

Festlegen des festen Verbindungspunkts oder des festen Verbindungsbereichs, der für jede Teilebaugruppe ausgewählt wurde, ohne ein Ziel der Optimierungsanalyse zu sein, und eines optimalen Verbindungskandidaten, der ein Ziel der Optimierungsanalyse sein soll, in dem Kraftfahrzeugkarosseriemodell, und

Durchführen einer Optimierungsanalyse, um einen optimierten Verbindungspunkt oder Verbindungsbereich zu erhalten, der die Teilebaugruppe in dem Kraftfahrzeugkarosseriemodell verbindet, wobei der feste Verbindungspunkt oder der feste Verbindungsbereich für jede Teilebaugruppe ausgewählt wird, wobei der Festverbindungsauswahlprozess umfasst:

einen ersten Festverbindungsauswahlschritt des Durchführens einer statischen Analyse oder einer dynamischen Analyse an dem Kraftfahrzeugkarosseriemodell, in dem die Verbindungskandidaten festgelegt sind, und des Auswählens eines ersten Festverbindungspunkts (43a) oder eines Festverbindungsbereichs aus den Verbindungskandidaten für jede Teilebaugruppe auf der Grundlage eines Ergebnisses der statischen Analyse oder der dynamischen Analyse,

einen zweiten Festverbindungsauswahlschritt des Auswählens eines Verbindungskandidaten, der den weitesten Abstand von dem ersten Festverbindungspunkt oder Festverbindungsbereich hat, als einen zweiten Festverbindungspunkt (43b) oder Festverbindungsbereich in der Teilebaugruppe,

einen dritten Festverbindungsauswahlschritt des Auswählens eines Verbindungskandidaten mit dem weitesten Abstand von einem Mittelpunkt auf einer geraden Linie, die den ersten Festverbindungspunkt oder Festverbindungsbereich und den zweiten Festverbindungspunkt oder Festverbindungsbereich verbindet, als einen dritten Festverbindungspunkt (43c) oder Festverbindungsbereich, und

einen vierten Festverbindungsauswahlschritt des Auswählens eines Verbindungskandidaten mit dem weitesten Abstand von dem dritten Festverbindungspunkt oder der dritten Festverbindungsfläche unter den Verbindungskandidaten, die den ersten Festverbindungspunkt oder die erste Festverbindungsfläche und den zweiten Festverbindungspunkt oder die zweite Festverbindungsfläche ausschließen, als einen vierten Festverbindungspunkt (43d) oder eine vierte Festverbindungsfläche,

wobei die Mehrzahl von Teilen als die Teilebaugruppe der Automobilkarosserie an den ersten, zweiten, dritten und vierten festen Fügepunkten oder an den ersten, zweiten, dritten und vierten festen Fügebereichen zusammengefügt werden.

2. Optimierungsanalyseverfahren einer Verbindungsposition einer Kraftfahrzeugkarosserie nach Anspruch 1, wobei im ersten Festverbindungsauswahlschritt des Festverbindungsauswahlprozesses ein Fügekandidat mit einer größten Dehnungsenergie als erster Festfügepunkt oder Festfügebereich ausgewählt wird.

3. Optimierungsanalyseverfahren einer Verbindungsposition einer Kraftfahrzeugkarosserie nach Anspruch 1, wobei in dem ersten Festverbindungsauswahlschritt des Festverbindungsauswahlprozesses ein Fügekandidat mit einer größten resultierenden Kraft aus einer Zugspannung und einer Schubspannung als erster Festfügepunkt oder Festfügebereich ausgewählt wird.

4. Optimierungsanalyseverfahren einer Verbindungsposition einer Kraftfahrzeugkarosserie nach einem der Ansprüche 1 bis 3, wobei bei dem Festverbindungsauswahlprozess ein Zentrum des Fügekandidaten als repräsentativer Punkt festgelegt wird und der Abstand für den Fügekandidaten in jeder Teilebaugruppe in einer Round-Robin-Methode berechnet wird.

5. Optimierungsanalysevorrichtung, die einen Computer einer Verbindungsposition einer Kraftfahrzeugkarosserie zum Durchführen einer Optimierungsanalyse des Erhaltens einer optimierten Position des Punktfügens oder des kontinuierlichen Fügens enthält, die zum Fügen einer Teilebaugruppe an einem Kraftfahrzeugkarosseriemodell eines Kraftfahrzeugs verwendet wird, das eine Vielzahl von Teilen enthält, und zum Fügen der Vielzahl von Teilen als eine Teilebaugruppe an einem Fügepunkt oder einem Fügebereich, wobei die Vorrichtung umfasst:

eine Fügekandidaten-Einstelleinheit, die so konfiguriert ist, dass sie einen Fügekandidaten an einer Position einstellt, die ein Kandidat zum Fügen der Teilebaugruppe ist;

eine Festverbindungs-Auswahleinheit, die konfiguriert ist, um vier oder mehr Festverbindungspunkte oder Festverbindungsbereiche, die notwendigerweise für jede Teilebaugruppe zu verbinden sind, aus den für jede Teilebaugruppe eingestellten Verbindungskandidaten auszuwählen; und

eine Fügeoptimierungs-Analyseeinheit, die konfiguriert ist, um

den festen Verbindungspunkt oder den festen Verbindungsbereich, der für jede Teilebaugruppe ausgewählt wurde, ohne ein Ziel der Optimierungsanalyse zu sein, und einen optimalen Verbindungskandidaten, der ein Ziel der Optimierungsanalyse sein soll, in dem Fahrzeugkarosseriemodell festzulegen, und

Durchführen einer Optimierungsanalyse zum Erhalten eines optimierten Fügepunkts oder Fügebereichs, der die Teilebaugruppe in dem Kraftfahrzeugkarosseriemodell unter Ausschluss des für jede Teilebaugruppe ausgewählten festen Fügepunkts oder festen Fügebereichs verbindet, wobei

die Festverbindungs-Auswahleinheit umfasst:

eine erste Festverbindungs-Auswahleinheit, die so konfiguriert ist, dass sie eine statische Analyse oder eine dynamische Analyse an dem Kraftfahrzeugkarosseriemodell durchführt, in dem die Verbindungskandidaten festgelegt sind, und einen ersten Festverbindungspunkt oder einen Festverbindungsbereich aus den Verbindungskandidaten für jede Teilebaugruppe auf der Grundlage eines Ergebnisses der statischen Analyse oder der dynamischen Analyse auswählt

eine zweite Festverbindungs-Auswahleinheit, die so konfiguriert ist, dass sie einen Verbindungskandidaten, der den weitesten Abstand von dem ersten Festverbindungspunkt oder Festverbindungsbereich hat, als einen zweiten Festverbindungspunkt oder Festverbindungsbereich in der Teilebaugruppe auswählt, eine dritte Festverbindungs-Auswahleinheit, die so konfiguriert ist, dass sie einen Fügekandidaten mit dem weitesten Abstand von einem Mittelpunkt auf einer geraden Linie, die den ersten Festverbindungspunkt oder Festverbindungsbereich und den zweiten Festverbindungspunkt oder Festverbindungsbereich verbindet, als einen dritten Festverbindungspunkt oder Festverbindungsbereich auswählt, und eine vierte Festverbindungs-Auswahleinheit, die so konfiguriert ist, dass sie einen Verbindungskandidaten, der den weitesten Abstand von dem dritten Festverbindungspunkt oder der dritten Festverbindungsfläche hat, unter den Verbindungskandidaten, die den ersten Festverbindungspunkt oder die erste Festverbindungsfläche und den zweiten Festverbindungspunkt oder die zweite Festverbindungsfläche ausschließen, als einen vierten Festverbindungspunkt oder eine vierte Festverbindungsfläche auswählt.

6. Optimierungsanalysevorrichtung einer Verbindungsposition einer Kraftfahrzeugkarosserie nach Anspruch 5, wobei in der ersten Festverbindungs-Auswahleinheit der Festverbindungs-Auswahleinheit ein Fügekandidat mit einer größten Dehnungsenergie als erster Festfügepunkt oder Festfügebereich ausgewählt wird.

7. Optimierungsanalysevorrichtung einer Verbindungsposition einer Kraftfahrzeugkarosserie nach Anspruch 5, wobei in der ersten Festverbindungs-Auswahleinheit der Festfüge-Auswahleinheit ein Fügekandidat mit einer größten resultierenden Kraft aus einer Zugspannung und einer Scherspannung als erster Festfügepunkt oder Festfügebereich ausgewählt wird.

8. Optimierungsanalysevorrichtung einer Verbindungsposition einer Kraftfahrzeugkarosserie nach einem der Ansprüche 5 bis 7, wobei in der Festverbindungs-Auswahleinheit ein Zentrum des Fügekandidaten als repräsentativer Punkt festgelegt wird und der Abstand für den Fügekandidaten in jeder Teilebaugruppe in einer Round-Robin-Weise berechnet wird.

## Revendications

1. Procédé d'analyse d'optimisation d'une position d'assemblage d'une carrosserie automobile pour effectuer, par un ordinateur, une analyse d'optimisation permettant d'obtenir une position optimisée d'assemblage ponctuel ou d'assemblage continu utilisée pour assembler un ensemble de pièces de la carrosserie automobile afin d'améliorer la rigidité dynamique liée aux caractéristiques de vibration de la carrosserie automobile d'une automobile en effectuant chacun des processus suivants sur un modèle de carrosserie automobile (37) d'une automobile comprenant une pluralité de pièces et pour assembler la pluralité de pièces en tant qu'ensemble de pièces au niveau d'un point d'assemblage ou d'une zone d'assemblage, le procédé comprenant :

un processus de définition de candidat à l'assemblage consistant à définir un candidat à l'assemblage à une position qui est un candidat pour assembler l'ensemble de pièces ; un processus de sélection d'assemblage fixe consistant à sélectionner au moins quatre points d'assemblage fixes ou zones d'assemblage fixes à assembler nécessairement pour chaque ensemble de pièces parmi les candidats à l'assemblage définis pour chaque ensemble de pièces ; et un processus d'analyse d'optimisation d'assemblage consistant à

définir, dans le modèle de carrosserie automobile, le point d'assemblage fixe ou la zone d'assemblage fixe sélectionné(e) pour chaque ensemble de pièces sans être une cible de l'analyse d'optimisation et un candidat à l'assemblage optimal pour être une cible de l'analyse d'optimisation, et effectuer une analyse d'optimisation permettant d'obtenir un point d'assemblage ou une zone d'assemblage optimisé(e) qui assemble l'ensemble de pièces dans le modèle de carrosserie automobile à l'exclusion du point d'assemblage fixe ou de la zone d'assemblage fixe sélectionné(e) pour chaque ensemble de pièces, dans lequel

le processus de sélection d'assemblage fixe comprend :

une première étape de sélection d'assemblage fixe consistant à effectuer une analyse statique ou une analyse dynamique sur le modèle de carrosserie automobile dans lequel les candidats à l'assemblage sont définis, et à sélectionner un premier point d'assemblage fixe (43a) ou une première zone d'assemblage fixe parmi les candidats à l'assemblage pour chaque ensemble de pièces sur la base d'un résultat de l'analyse statique ou de l'analyse dynamique,

une deuxième étape de sélection d'assemblage fixe consistant à sélectionner un candidat à l'assemblage ayant la distance la plus éloignée du premier point d'assemblage fixe ou de la première zone d'assemblage fixe en tant que deuxième point d'assemblage fixe (43b) ou deuxième zone d'assemblage fixe dans l'ensemble de pièces,

une troisième étape de sélection d'assemblage fixe consistant à sélectionner un candidat à l'assemblage ayant la distance la plus éloignée d'un point médian sur une ligne droite reliant le premier point d'assemblage fixe ou la première zone d'assemblage fixe et le deuxième point d'assemblage fixe ou la deuxième zone d'assemblage fixe en tant que troisième point d'assemblage fixe (43c) ou troisième zone d'assemblage fixe, et

une quatrième étape de sélection d'assemblage fixe consistant à sélectionner un candidat à l'assemblage ayant la distance la plus éloignée du troisième point d'assemblage fixe ou de la troisième zone d'assemblage fixe parmi les candidats à l'assemblage à l'exclusion du premier point d'assemblage fixe ou de la première zone d'assemblage fixe et du deuxième point d'assemblage fixe ou de la deuxième zone d'assemblage fixe en tant que quatrième point d'assemblage fixe (43d) ou quatrième zone d'assemblage fixe,

dans lequel la pluralité de pièces sont assemblées comme étant l'ensemble de pièces de la carrosserie automobile au niveau des premier, deuxième, troisième et quatrième points d'assemblage fixes ou au niveau des première, deuxième, troisième et quatrième zones d'assemblage fixes.

2. Procédé d'analyse d'optimisation d'une position d'assemblage d'une carrosserie automobile selon la revendication 1, dans lequel, dans la première étape de sélection d'assemblage fixe du processus de sélection d'assemblage fixe, un candidat à l'assemblage ayant l'énergie de déformation la plus grande est sélectionné comme étant le premier point d'assemblage fixe ou la première zone d'assemblage fixe.

3. Procédé d'analyse d'optimisation d'une position d'assemblage d'une carrosserie automobile selon la revendication 1, dans lequel, dans la première étape de sélection d'assemblage fixe du processus de sélection d'assemblage fixe, un candidat à l'assemblage ayant la force résultante la plus grande d'une contrainte de traction et d'une contrainte de cisaillement est sélectionné comme étant le premier point d'assemblage fixe ou la première zone d'assemblage fixe.

4. Procédé d'analyse d'optimisation d'une position d'assemblage d'une carrosserie automobile selon l'une quelconque des revendications 1 à 3, dans lequel, dans le processus de sélection d'assemblage fixe, un centre du candidat à l'assemblage est défini comme point représentatif, et la distance est calculée de manière circulaire pour le candidat à l'assemblage dans chaque ensemble de pièces.

5. Dispositif d'analyse d'optimisation, qui comprend un ordinateur, d'une position d'assemblage d'une carrosserie automobile pour effectuer une analyse d'optimisation permettant d'obtenir une position optimisée d'assemblage ponctuel ou d'assemblage continu utilisée pour assembler un ensemble de pièces sur un modèle de carrosserie automobile d'une automobile comprenant une pluralité de pièces et pour assembler la pluralité de pièces en tant qu'ensemble de pièces au niveau d'un point d'assemblage ou d'une zone d'assemblage, le dispositif comprenant :

une unité de définition de candidat à l'assemblage configurée pour définir un candidat à l'assemblage à une position qui est un candidat pour assembler l'ensemble de pièces ;
une unité de sélection d'assemblage fixe configurée pour sélectionner au moins quatre points d'assemblage fixes ou zones d'assemblage fixes à assembler nécessairement pour chaque ensemble de pièces parmi les candidats à l'assemblage définis pour chaque ensemble de pièces ; et
une unité d'analyse d'optimisation d'assemblage configurée pour

définir, dans le modèle de carrosserie automobile, le point d'assemblage fixe ou la zone d'assemblage fixe sélectionné(e) pour chaque ensemble de pièces sans être une cible de l'analyse d'optimisation et un candidat à l'assemblage optimal pour être une cible de l'analyse d'optimisation, et
effectuer une analyse d'optimisation permettant d'obtenir un point d'assemblage ou une zone d'assemblage optimisé(e) qui assemble l'ensemble de pièces dans le modèle de carrosserie automobile à l'exclusion du point d'assemblage fixe ou de la zone d'assemblage fixe sélectionné(e) pour chaque ensemble de pièces, dans lequel

l'unité de sélection d'assemblage fixe comprend :

une première unité de sélection d'assemblage fixe configurée pour effectuer une analyse statique ou une analyse dynamique sur le modèle de carrosserie automobile dans lequel les candidats à l'assemblage sont définis, et pour sélectionner un premier point d'assemblage fixe ou une première zone d'assemblage fixe parmi les candidats à l'assemblage pour chaque ensemble de pièces sur la base d'un résultat de l'analyse statique ou de l'analyse dynamique,

une deuxième unité de sélection d'assemblage fixe configurée pour sélectionner un candidat à l'assemblage ayant la distance la plus éloignée du premier point d'assemblage fixe ou de la première zone d'assemblage fixe en tant que deuxième point d'assemblage fixe ou deuxième zone d'assemblage fixe dans l'ensemble de pièces,

une troisième unité de sélection d'assemblage fixe configurée pour sélectionner un candidat à l'assemblage ayant la distance la plus éloignée d'un point médian sur une ligne droite reliant le premier point d'assemblage fixe ou la première zone d'assemblage fixe et le deuxième point d'assemblage fixe ou la deuxième zone d'assemblage fixe en tant que troisième point d'assemblage fixe ou troisième zone d'assemblage fixe, et

une quatrième unité de sélection d'assemblage fixe configurée pour sélectionner un candidat à l'assemblage ayant la distance la plus éloignée du troisième point d'assemblage fixe ou de la troisième zone d'assemblage fixe parmi les candidats à l'assemblage à l'exclusion du premier point d'assemblage fixe ou de la première zone d'assemblage fixe et du deuxième point d'assemblage fixe ou de la deuxième zone d'assemblage fixe en tant que quatrième point d'assemblage fixe ou quatrième zone d'assemblage fixe.

6. Dispositif d'analyse d'optimisation d'une position d'assemblage d'une carrosserie automobile selon la revendication 5, dans lequel, dans la première unité de sélection d'assemblage fixe de l'unité de sélection d'assemblage fixe, un candidat à l'assemblage ayant l'énergie de déformation la plus grande est sélectionné comme étant le premier point d'assemblage fixe ou la première zone d'assemblage fixe.

7. Dispositif d'analyse d'optimisation d'une position d'assemblage d'une carrosserie automobile selon la revendication 5, dans lequel, dans la première unité de sélection d'assemblage fixe de l'unité de sélection d'assemblage fixe, un candidat à l'assemblage ayant la force résultante la plus grande d'une contrainte de traction et d'une contrainte de cisaillement est sélectionné comme étant le premier point d'assemblage fixe ou la première zone d'assemblage fixe.

8. Dispositif d'analyse d'optimisation d'une position d'assemblage d'une carrosserie automobile selon l'une quelconque des revendications 5 à 7, dans lequel, dans l'unité de sélection d'assemblage fixe, un centre du candidat à l'assemblage est défini comme point représentatif, et la distance est calculée de manière circulaire pour le candidat à l'assemblage dans chaque ensemble de pièces.

# FIG.1

1

ARITHMETIC PROCESSING UNIT ——11

JOINING CANDIDATE SETTING UNIT ——13

FIXED JOINING SELECTION UNIT ——17

FIRST FIXED JOINING SELECTION UNIT ——17a

SECOND FIXED JOINING SELECTION UNIT ——17b

THIRD FIXED JOINING SELECTION UNIT ——17c

FOURTH FIXED JOINING SELECTION UNIT ——17d

JOINING OPTIMIZATION ANALYSIS UNIT ——19

FREQUENCY RESPONSE ANALYSIS UNIT ——19a

LOADING CONDITION DETERMINATION UNIT ——19b

OPTIMIZATION ANALYSIS MODEL GENERATION UNIT ——19c

OPTIMIZATION ANALYSIS CONDITION SETTING UNIT ——19d

OPTIMIZATION ANALYSIS UNIT ——19e

3 — DISPLAY DEVICE

5 — INPUT DEVICE

7 — STORAGE DEVICE

23 — AUTOMOTIVE BODY MODEL FILE

9 — WORKING DATA MEMORY

# FIG.2

# FIG.3

(a)

(b)

# FIG.4

```
                    ( START )
                        │
                        ▼
          ┌──────────────────────────┐
          │  JOINING CANDIDATE       │───P1
          │  SETTING PROCESS         │
          └──────────────────────────┘
                        │
                        ▼
          ┌──────────────────────────┐
          │ FIXED JOINING SELECTION  │───P5
          │        PROCESS           │
          │  ┌────────────────────┐  │
          │  │  FIRST FIXED       │  │───S5a
          │  │  JOINING           │  │
          │  │  SELECTION STEP    │  │
          │  └────────────────────┘  │
          │           │              │
          │           ▼              │
          │  ┌────────────────────┐  │
          │  │  SECOND FIXED      │  │───S5b
          │  │  JOINING           │  │
          │  │  SELECTION STEP    │  │
          │  └────────────────────┘  │
          │           │              │
          │           ▼              │
          │  ┌────────────────────┐  │
          │  │  THIRD FIXED       │  │───S5c
          │  │  JOINING           │  │
          │  │  SELECTION STEP    │  │
          │  └────────────────────┘  │
          │           │              │
          │           ▼              │
          │  ┌────────────────────┐  │
          │  │  FOURTH FIXED      │  │───S5d
          │  │  JOINING           │  │
          │  │  SELECTION STEP    │  │
          │  └────────────────────┘  │
          └──────────────────────────┘
                        │
                        ▼
          ┌──────────────────────────┐
          │ JOINING OPTIMIZATION     │───P7
          │ ANALYSIS PROCESS         │
          │  ┌────────────────────┐  │
          │  │ FREQUENCY RESPONSE │  │───S7a
          │  │ ANALYSIS STEP      │  │
          │  └────────────────────┘  │
          │           │              │
          │           ▼              │
          │  ┌────────────────────┐  │
          │  │ LOADING CONDITION  │  │───S7b
          │  │ DETERMINATION STEP │  │
          │  └────────────────────┘  │
          │           │              │
          │           ▼              │
          │  ┌────────────────────┐  │
          │  │ OPTIMIZATION       │  │───S7c
          │  │ ANALYSIS MODEL     │  │
          │  │ GENERATION STEP    │  │
          │  └────────────────────┘  │
          │           │              │
          │           ▼              │
          │  ┌────────────────────┐  │
          │  │ OPTIMIZATION       │  │───S7d
          │  │ ANALYSIS CONDITION │  │
          │  │ SETTING STEP       │  │
          │  └────────────────────┘  │
          │           │              │
          │           ▼              │
          │  ┌────────────────────┐  │
          │  │ OPTIMIZATION       │  │───S7e
          │  │ ANALYSIS STEP      │  │
          │  └────────────────────┘  │
          └──────────────────────────┘
                        │
                        ▼
                    (  END  )
```

# FIG.5

| (a)<br>COMPARATIVE EXAMPLE 1<br>(JOINED AT ONE POINT) | (b)<br>COMPARATIVE EXAMPLE 2<br>(JOINED AT FOUR POINTS) |
|---|---|
| 45 | 45 |
| (c)<br>INVENTION EXAMPLE 1<br>(JOINED AT FOUR POINTS) | |
| 45 | |

# FIG.6

| (a)<br>COMPARATIVE EXAMPLE 1<br>(JOINED AT ONE POINT) | (b)<br>COMPARATIVE EXAMPLE 2<br>(JOINED AT FOUR POINTS) |
|---|---|
| 45 | 45 |
| (c)<br>INVENTION EXAMPLE 1<br>(JOINED AT FOUR POINTS) | |
| 45 | |

# FIG.7

| (a)<br>COMPARATIVE EXAMPLE 1<br>(JOINED AT ONE POINT) | (b)<br>COMPARATIVE EXAMPLE 2<br>(JOINED AT FOUR POINTS) |
|---|---|
| 45 | 45 |

| (c)<br>INVENTION EXAMPLE 1<br>(JOINED AT FOUR POINTS) | |
|---|---|
| 45 | |

# FIG.8

(a)

(b)

# FIG.9

(a)

(b)(i)

(b)(ii)

(b)(iii)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010250818 A

- JP 2013025593 A